# EUROPEAN PATENT APPLICATION

(11) **EP 4 212 890 A1**
(43) Date of publication of application: **19.07.2023**
(21) Application number: 22382021.8
(22) Date of filing: 17.01.2022
(51) Int. Cl.: G01R 29/08, G01V 3/00

(54) **METHOD AND DEVICE TO MEASURE DISRUPTIONS IN A CONTROLLED ELECTROMAGNETIC FIELD**

(71) Applicant: Ontech Security, SL, 41309 La Rinconada Sevilla (ES)
(72) Inventor: Aponte Luis, Juan, 41309 La Rinconada (Sevilla) (ES)
(74) Representative: Sahuquillo Huerta, Jesús

(57) **Abstract**

A method and device to measure disruptions in a controlled electromagnetic field comprising: a CEMF shield module; an electrode management module; a CEMF front-end module; a CEMF acquisition module; a memory module; a communications module; and a system manager module. This invention refers to a device comprising a controlled electromagnetic field (CEMF controlled electromagnetic field) sensor physically integrated in an ASIC (Application-Specific Integrated Circuit). Another object of this invention is a method to measure electromagnetic fields surrounding a conductor, as well as a plurality of uses for the sensor in different technical applications, such as the localisation of people, mixed reality, devices, IoT, domestic and industrial security applications, robotics, military applications, and security applications for transporting cargo and people, work-related and domestic prevention and security applications and applications for the logistics sector and fluid control and detection in bathrooms.

## Description

### Technical field

This invention refers to a device comprising a controlled electromagnetic field (CEMF controlled electromagnetic field) sensor physically integrated in an ASIC (Application-Specific Integrated Circuit). Another object of this invention is a method to measure electromagnetic fields surrounding a conductor, as well as a plurality of uses for the sensor in different technical applications, such as the localisation of people, mixed reality, devices, loT, domestic and industrial security applications, robotics, military applications, and security applications for transporting cargo and people, work-related and domestic prevention and security applications and applications for the logistics sector.

### Background of the invention

When an electric charge moves over a conductor it creates an EM field around it. The oscillation of the source charge generates a wave that radiates energy from said conductor, the EM field being the means that enables said energy to be transported remotely from its emitter.

An electromagnetic wave is an electric field and another magnetic one coupled together that oscillate at the same frequency as the electric source charge. At a short distance from the emitter, both fields are independent, but in the far-field zone both are coupled and, by knowing one, the value of the other can be determined.

In the known state of the art, capacitive sensors have been widely used in different applications, such as controlling the level of a fluid inside a container, controlling the fill-level and position of objects, or counting materials on conveyor belts. In another type of application related to the medical sector, these types of sensors have also been used to measure intraocular pressure, intracranial pressure, diagnosing pulmonary diseases or measuring the respiratory system.

Within capacitive sensors, capacitive systems based on an oscillator are known wherein the oscillation frequency is used as a parameter to determine the value of the capacity to be measured. Of the different types of oscillators that exist, however, the oscillator used in applications like the one described in this invention must resolve two technical problems:
- Frequency sensitivity must be high regarding small variations in the capacity to be measured. This question is very important because when an object approaches the sensor, a disruption of the EM field generated by the sensor will occur and this small variation generated in the field is of vital importance in determining how far away the object is.
- That the oscillator generates a stable frequency when faced with phenomena such as vibrations, temperature changes and, ultimately, any possible interference regarding the sensor.

The basic principles of the detection and use of disruptions in electromagnetic fields for the detection of people are described, for example, in document GB1404838. According to this invention, an alarm system comprising at least one ultra-high frequency (UHF) oscillator circuit, at least one electromagnetic wave radiation element connected to the oscillator circuit in order to irradiate ultra-high frequency electromagnetic radiation are provided wherein each one of said electromagnetic wave radiation elements is arranged so that movement in the vicinity of the element produces a very low frequency variation in the impedance of the ultra-high frequency of the element and, therefore, a very low frequency variation in the oscillation frequency of the oscillator circuit.

On the other hand, the sensor should be operative within a wireless sensor network. To this effect, it is necessary that the wireless technology used should be suitable for low-consumption and low-data-transfer rate at the same time as achieving a high level of reliability and security in the communications that enable its integration with other types of sensors, such as optical sensors, CCD sensors or any other type of sensors.

Document WO9741458 describes a quasi-electrostatic detection system that surrounds an electrically conductive mass with an electric field the magnitude of which is detected in one or more locations to analyse a property of interest with respect to the mass. The object intercepts a part of the electric field that extends between the "emitter" electrode coupled to a CA and the other "receiver" electrodes, the amount of the field intercepted according to the size and orientation of the mass detected, regardless of whether the mass provides an earth connection pathway, and the geometry of the electrodes distributed. Due to the response of the field to an object being a complex non-linear function, the addition of electrodes can always be distinguished among other cases. In other words, each electrode represents an independent weighting of the mass within the field; adding an electrode provides information with respect to that mass which is not redundant for the information provided by the other electrodes.

Document WO03022641 describes a device for detecting the size and location of an occupant of a vehicle which includes a conductor that is electrically coupled to a voltage signal generator and fitted inside the vehicle seat. The conductor generates a periodic electric field. A plurality of electrostatic sensor antennae is fitted adjacent to the roof and can detect at least one part of the electric field. A detection circuit determines the size and location of a vehicle occupant based on an incidental quantity of electric field in each electrostatic antenna of the sensor.

Document US2004090234 describes well-logging devices and methods for determining the resistivity of the formation to multiple (>3) research depths. At least one transmitter antenna and at least two receiver antennae which are mounted in a logging tool casing, in a substantially common axis. The antennae are untuned wire coils. The electromagnetic energy is emitted at multiple frequencies from the transmitter to the formation. The receiver's antennae, which are separated from each other and from the transmitter, detect the electromagnetic energy reflected.

Finally, document EP256805 describes a sensor comprising an analysis and control circuit and a reference electrode coupled to the analysis and control circuit. The electrode sensor of a capacitive sensor is coupled to said analysis and control circuit. The capacitive sensor is adapted to detect the proximity of an object. The analysis and control circuit of the sensor is designed so that the capacitance data detected between the sensor electrode and the reference electrode are variable to the potential of an objective electrode by means of an analysis and control circuit of the sensor.

The above documents display the particularity of being configured by means of an emitter-receiver structure, in other words, that there is an electrode that emits and an electrode that receives a signal, and so the disruptions between said emitter and said receiver are measured. Meanwhile, this presents a certain complexity in the circuitry. Furthermore, it does not permit the emission of the magnetic field to be controlled since the dispersion in the emitter is not defined in a determined direction so that it does not restrict its use and application to very specific cases wherein it is possible to implement or use both emitters and receivers.

Document EP2980609 discloses a sensor capable of measuring electrostatic fields and their variations to determine human presence in an area close to and surrounding said probe and differentiate it from any other animal or object. The electrostatic fields sensor, whose signals are uncoupled from each other by means of an uncoupling circuit, and wherein said circuits for measuring electrostatic fields are connected to an antenna consisting of a coaxial cable by means of a phase measurement circuit. This invention shares the same technical objective and resolves the same technical problems as this document, albeit with an alternative and different solution. Other documents from the same applicant as patent EP2980609 reflect solutions based on the same technology and physical properties such as documents EP3190569, EP3076206, WO2017077165 and WO2017070166.

The present invention, just like document EP280609 and/or WO2019197677, is based on the measurement of the variation of a controlled magnetic field surrounding a conductor that acts like a probe or antenna when said body is affected by the influence of a charged body such as the human body. In other words, that the human body, just like any other existent body, presents intrinsic electrical characteristics, dependent on the materials, density, volume, temperature, and conductivity. Potential differences between the different objects give rise to electrostatic discharges from one object to another when they come into contact or are infinitesimally close. This effect is exploited by the sensor that is the object of this invention, managing to measure continuously the fluctuations that said field cause in a circuit connected to the conductor that acts like an antenna. Notwithstanding, this invention describes a series of improvements to the technology described in the state of the art as will be described in detail in this document.

### Summary of the invention

The object of this invention is a method and a device comprising a controlled electromagnetic field sensor with which it is possible to detect the presence of any nearby object by means of the detection of the disruption in an electromagnetic field around a sole conductor which is configured as an antenna that emits a controlled electromagnetic field and, at the same time, detects the variation or disruption to said field. All this according to the device described in claim 1 and/or the method of claim 34. In the dependant claims to it, specific embodiments of the device of the invention are described. Other aspects of the invention are described in independent embodiments.

One of the virtues of this invention is that it can emit the electromagnetic field in a controlled way by means of an active screening by means of a high impedance circuit so that, by means of the only conductive element comprising the emitter-receiver antenna, it is possible to direct the electromagnetic field towards a determined zone of influence and configurable for each specific application as will be described subsequently in this document.

The present invention relates to improvements in the device disclosed in WO2019197677. Thanks to this structure, the device is capable of distinguishing, as a function of the magnitude of the change -i.e., the disruption generated- if there is a person, an animal or any other object, since the invention is based on the device's capacity to measure the variations of the electromagnetic field existent around each one of the antennae the device is connected to, since the device can be connected to various antennae, with the particularity that each one of the antennae acts independently with respect to the others, in other words, each antenna has the same capabilities and functionalities in the detection of the disruption - it emits a controlled electromagnetic field and, at the same time, detects disruptions to this field-.

The device essentially comprises an RLC-circuit that generates a wave and whose output is connected to at least one antenna like those indicated. Meanwhile, the circuit has the particularity of being a closed loop since the signal from the antenna is, at the same time, configured as the input signal from the RLC-circuit. This configuration enables the antenna signal to be followed, in other words, when there is a disruption and the magnitude of the field changes, this change will immediately affect the input of the RLC-circuit, thereby significantly increasing the sensitivity of the device and, furthermore, makes the traditional emitter-receiver configuration described in the state of the art unnecessary. Another important benefit is that said configuration is not affected by external noise since the closed-loop configuration logically cancels out any noise that may exist in the signal. This closed-loop configuration, already described in document WO2019197677 from the same applicant, is significantly improved in its sensitivity and response with the circuit and configuration described in this invention.

Thus, this invention, just like document WO2019197677 starts from the fact that, the human body, just like any other existent object, displays its own electrical characteristics, dependent on the materials, density, volume, temperature, and conductivity. The differences of potential between different objects give rise to a plurality of electromagnetic interactions from one object to another when they enter in contact or are nearby. This effect generates fluctuations in the electromagnetic field surrounding the antenna, which are continuously measured by the device. To be precise, the measurement of this signal from the antenna due to a disruption -i.e., the measurement of the change in the antenna's impedance due to a disruption- in turn shapes the controlled electromagnetic field surrounding the antenna and enables it to be determined, according to the change caused, which object has caused said disruption -person, animal, or thing-.

More specifically, the improvements to the device disclosed in WO2019197677 cover several functionalities of the CEMF technology. Some of the technical improvements address the same functionality, they extend the original functionality or describe different ways of implementing it. By joining the required functionalities into an ASIC, a complete CEMF solution can be integrated.

The applications of the device that is the object of the invention are all those requiring the detection of an object prior to it resulting in the violation of the restricted space. Amongst these applications we can highlight the following: the localisation of people, mixed reality, loT, devices, domestic and industrial security applications, robotics, military applications, and security applications for transporting cargo and people, work-related and domestic prevention and security applications and applications for the logistics sector.

The device applied to security systems in industrial installations involves notifying a specific user or operator that he/she is approaching a determined restricted or unauthorised zone. This enables -for example, in the operational zone of a robot arm, for it to be paralysed when an operator is within its operating range, regardless of whether the operator him/herself is subsequently called upon to explain if he/she were not authorised to be there, for which purpose the system can also identify the operator.

Also, an object of the invention is an access control in restricted areas comprising at least one of the following: a virtual fence, a crossings detector in sensitive, restricted, or dangerous zones such as railway platforms or loading docks for land or maritime transport, as well as safety in the use of domestic appliances; or a combination of the above.

The virtual fence or crossings detector comprises, at least, a device according to this invention, with the particularity of having a plurality of antennae configured to delimit a determined work or transit area, so that any object, person, or animal that affects, at least, one generated field in, at least, one of the antennae, generates an alarm, a notification or similar. It is also intended that said signal might activate physical closure element -for example, the automatic closing of a door or physical barrier-.

Similarly, the device of this invention can be used in the surveillance and control of railway platforms, loading docks for land or maritime transport, access to safes, monitoring exhibitions of valuable objects, such as works of art, and safety control in the use of domestic appliances.

In all the above cases, the antenna or antennae delimit a determined control area or restricted use zone, so that any object, person, or animal that generates a disruption in at least one antenna connected to at least one device will generate an alarm, a notification, or similar. It is also intended that said signal might activate physical closure element -for example, the automatic closing of a door or physical barrier-.

Also, an object of this invention is a detector of objects adhered to a vehicle by means of the detection of the approach of the person and/or the characterisation of the foreign element. In a second aspect of this use, it is configured as a security element inside vehicles, for example, in the detection of the correct position of security anchors or the detection of people in bathrooms, cellars or restricted areas of the vehicles themselves, such as the driver's cab. Finally, the security system is capable of precisely detecting the position of the vehicle in a car park or parking area.

Another object of the invention is its use as a weapons and explosives detector and a method for the detection of weapons and explosives. More specifically, this invention refers to the detection of IEDs (Improvised Explosive Devices) in the passage of vehicles, the detection of limpet bombs, the detection of land mines or the detection of weapons, by means of the detection of the approach of the person or characterisation of a foreign element that may be deemed a threat.

Another object of the invention is its use as a fluid detector and controller. More specifically, the present invention makes it possible to detect the passage of fluids and the control of fluid consumption, for example, in bathrooms, both in public and private use.

Also, an object of the invention is its use in mixed reality. Mixed reality (MR) is the merging of real and virtual worlds to produce new environments and visualizations, where physical and digital objects co-exist and interact in real time. Mixed reality does not exclusively take place in either the physical world or virtual world but is a hybrid of reality and virtual reality. Augmented reality, a related term, takes place in the physical world, with information or objects added virtually. There are many practical applications of mixed reality, including design, entertainment, military training, and remote working. For example, the present invention is able to detect the movements of a user in a mixed reality environment.

loT is also object of this invention. loT covers a wide range of applications, a sample is a device that can be fitted or connected to a computer in such a way that senses the presence of a user. Such device communicates to a server when the employee is on his/her workplace to allow companies operate remotely with certain guaranties of success.

Lastly, a final use in domestic security applications, conferring the capacity of preventive detection of intruders to doors, windows, walls or, in general, any other architectonic enclosure, in other words, the device of the invention is used for the detection of the intrusion before it takes place, precisely thanks to its capacity to measure the disruptions at distance.

The scope of this invention is defined by the claims, which are incorporated in this section for reference. Throughout the description and the claims, the word "comprises", and its variants, does not intend to exclude other technical characteristics, components, or steps. For those skilled in the art, other objects, benefits, and characteristics of the invention will emanate partly from the description and partly from using the invention. The following examples of use and associated figures are provided for illustrative purposes and are non-limiting. Furthermore, this invention covers all the possible combinations of the preferred embodiments indicated here.

### Brief description of the drawings

Below follows a brief description of a series of drawings and diagrams which help to understand the invention better and which expressly relate to an embodiment of said invention which is presented as a non-limiting example of it.
Figure 1 - CEMF ASIC - Block diagram
Figure 2 - Tracking GND signals
Figure 3 - RLC-circuit based shield - Theory of operation
Figure 4 - Energy efficient Shield
Figure 5 - Multilayer Shield Can
Figure 6 - Analog CEMF differentiation
Figure 7 - Per-channel compensation
Figure 8- Integrated Front-End and Energy Storage Capacitor
Figure 9 - CEMF Signal Envelope
Figure 10 - Multi Frequency Acquisition
Figure 11 - Frequency interference shape on a Frequency Scan
Figure 12 - Dynamic Differentiation
Figure 13 - Flexible compensation time
Figure 14 - Continuous acquisition
Figure 15 - Real time acquisition
Figure 16 - Virtual acquisition
Figure 17 - Extended acquisition
Figure 18 - Parallel acquisition
Figure 19 - Harmonic acquisition
Figure 20 - CEMF Spectrum acquisition
Figure 21 - Partial acquisition
Figure 22 - Dynamic Start-Up Time
Figure 23 - Virtual channels
Figure 24 - Fix sequence time
Figure 25 - Always on CLK_SYS

### Detailed description of preferred embodiments of the invention

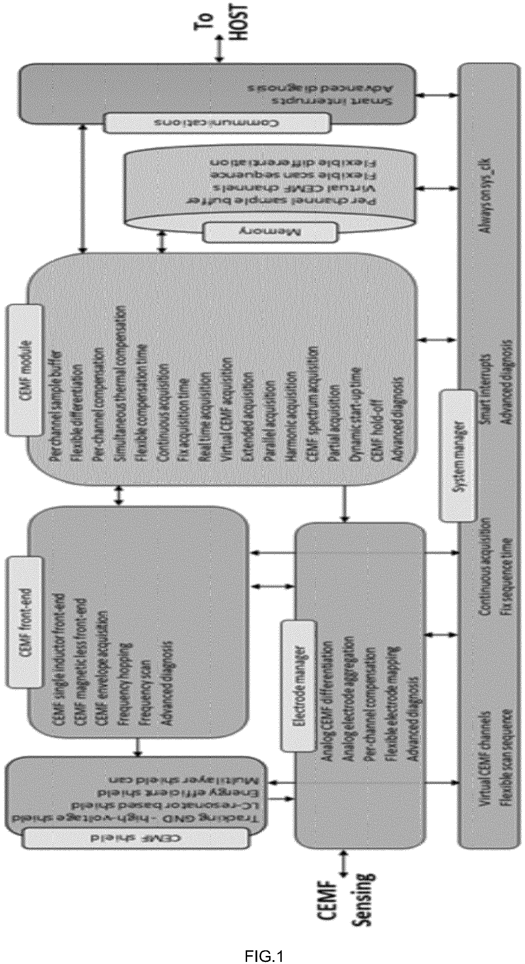

The different aspects of the invention comprise a controlled electromagnetic field (hereinafter CEMF) sensor capable of detecting a disruption in the electromagnetic field surrounding a sole conductor or antenna that has the particularity of emitting a controlled electromagnetic field and, at the same time, detecting any disruption in said field so that, by means of the characterisation of said disruption, it is possible to detect and discern the object that generated said disruption. In Figure 1 it is displayed where the different modules and sub-modules covered in this document are located. As it can be seen some sub-modules are in more than one module. This means that the sub-module is implemented across several modules (e.g., advanced diagnosis). Also, some of the sub-modules are complementary. This means that must be instantiated simultaneously in the module for it to be able to work. Other sub-modules are redundant and can or cannot be instantiated simultaneously as the ASIC designer chooses to do.

Therefore, with respect to figure 1, the device according with the invention comprises:
a CEMF shield module further comprising at least one of the following sub-modules: a tracking GND high voltage shield sub-module; an RLC-circuit based shield; an energy efficient shield; and/or a multilayer shield can;
an electrode management module further comprising at least one of the following sub-modules: an analog CEMF differentiation sub-module; and/or a per-channel compensation sub-module;
a CEMF front-end module further comprising at least one of the following sub-modules: a CEMF magnetic less front-end sub-module; a CEMF envelope acquisition sub-module; a frequency hopping sub-module; and/or a frequency scan sub-module;
a CEMF acquisition module further comprising at least one of the following sub-modules: a flexible differentiation sub-module; a per-channel compensation sub-module; a simultaneous compensation sub-module; a flexible compensation time sub-module; a continuous acquisition sub-module; a real-time acquisition sub-module; an extended acquisition sub-module; a virtual CEMF acquisition sub-module; a parallel acquisition sub-module; a harmonic acquisition sub-module; a CEMF spectrum acquisition sub-module; a partial acquisition sub-module; and/or a dynamic start-up time sub-module;
a memory module further comprising at least one of the following sub-modules: a virtual CEMF channel sub-module; a flexible scan sequence sub-module; and/or a flexible differentiation sub-module;
a communications module comprising a smart interrupts sub-module; and
a system manager module further comprising at least one of the following sub-modules: a virtual CEMF channel sub-module; a continuous acquisition sub-module; a fix sequence time sub-module; and/or an always on SYS_CLK sub-module.

In another aspect of the invention, the device implements the following method:
a CEMF shield process further comprising at least one of the following steps: a tracking GND high voltage shield step; an RLC-circuit based shield step; an energy efficient shield step; and/or a multilayer shield can step;
an electrode management process further comprising at least one of the following steps: an analogic CEMF differentiation step and/or a per-channel compensation step;
a CEMF front-end process further comprising at least one of the following steps: a CEMF magnetic less front-end step; a CEMF envelope acquisition step; a frequency hopping step; and/or a frequency scan step;
a CEMF acquisition process further comprising at least one of the following steps: a flexible differentiation step; a per-channel compensation step; a simultaneous compensation step; a flexible compensation time step; a continuous acquisition step; a real-time acquisition step; an extended acquisition step; a virtual CEMF acquisition step; a parallel acquisition step; a harmonic acquisition step; a CEMF spectrum acquisition step; a partial acquisition step; and/or a dynamic start-up time step;
a memory process further comprising at least one of the following steps: a virtual CEMF channel step; a flexible scan sequence step; and/or a flexible differentiation step;
a communications process comprising a smart interrupts step; and
a system manager process further comprising at least one of the following steps: a virtual CEMF channel step; a continuous acquisition step; a fix sequence time step; and/or an always on SYS_CLK step.

In general terms, the control-electromagnetic field is generated by electrical signals populated by the ASIC as "CEMF sensing" this are input-output signals, and simultaneously generate and sense the field. These signals are connected to the ASIC connections through an Electrode Manager module, in charge of providing great flexibility on what and how the CEMF wants to be generated. The Electrode manager sources its signals from CEMF shield and CEMF front-end. The CEMF shield block generated a signal used to control the field into some areas as well as to protect the CEMF signal and boost the CEMF sensitivity. The CEMF front-end generates the CEMF signal creating and sampling the field simultaneously, and it is also connected to the CEMF module. The CEMF module takes the CEMF signal and acquires it according to the configuration of the ASIC. It also processes the patterns and stores the data into the memory. Finally, the communications block provides a path for the host of the system to read and write to the memory and registers of the ASIC. All blocks are also connected to the system manager that monitors the overall execution of process.

Throughout the present description a "Wardiam Module" should be interpreted as a controlled electromagnetic field sensor module implemented in the silicon area of an ASIC. Essentially, the CEMF sensor module comprises an RLC-circuit connected to at least one electrode; a digital module configured to process the signals received from the RLC-circuit; and a processor connected to the digital module. A detailed description of the internal structure of the controlled electromagnetic sensor module can be found in WO2019197677.

In this description, the terms «circuit» and «circuitry» refer to the electronic physical components -i.e., hardware components- and any software and/or firmware -machine code-that can configure or be susceptible to configuring the hardware and/or be associated in any way with the hardware. In certain parts of the description, hardware and software may be abbreviated to HW and SW, respectively.

### Detailed description of the CEMF shield module and process

As it is previously disclosed referring to figure 1 the CEMF shield module further comprises, at least, one of the following sub-modules: a tracking GND high voltage shield sub-module; a RLC-Circuit based shield; an energy efficient shield; and/or a multilayer shield can sub-module.

### Tracking GND high voltage shield sub-module

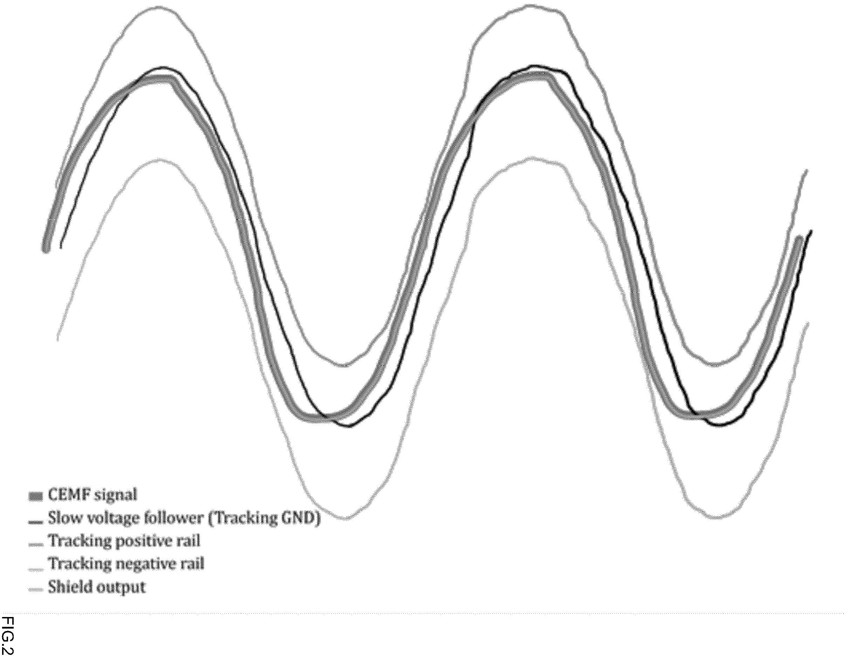

The generation of a high voltage high current and high accuracy shield is complicated, as fast buffers tent to be low voltages and, and high voltage buffers tend to be slow. The tracking GND high voltage shield sub-module (fig.2) solves this issue by combining both, slow high voltage buffers with fast low voltage buffers to deliver a high voltage high speed buffer capable of shielding a high voltage CEMF signal.

A high voltage low speed buffer is used to follow the input signal with a high degree of error. Around this output a supply voltage is created by connecting to it the GND output of a floating DC/DC converter. The input signal must live within the generated supply that follows the input voltage. At this point, a high speed, high current low voltage fast buffer can be supplied with the floating rails to accurately follow the input rail, delivering a precise shield output.

### RLC-circuit based shield sub-module

Traditionally, a voltage follower has been used as shield circuit. One of the biggest limitations of this technique is that it requires high voltage power supply rails (often positive and negative). This new approach allows for a shield signal generation from a single positive low voltage rail.

The idea is to use an RLC-circuit to build a signal that matches frequency, phase, and amplitude of the input signal. For this reason, three close loop controls modify the output frequency and delay, to match frequency and phase of the input, as well as the current, to track amplitude.

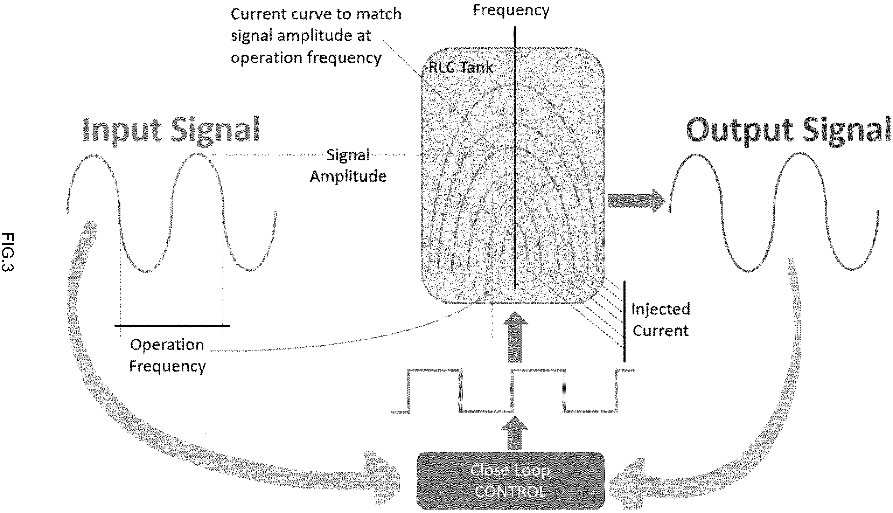

As it can be seen in the figure 3, both, frequency and current will affect over the output amplitude. Also, the delay of the RLC-circuit itself will change as the shield load changes. Changes on the shield load will change the delay and the amplitude of the output. Therefore, the close loop is essential to continuously compensate for load changes, frequency changes, and/or amplitude changes.

Thus, this sub-module allows for a high voltage shield to be generated from a single low voltage.

### Energy efficient shield sub-module

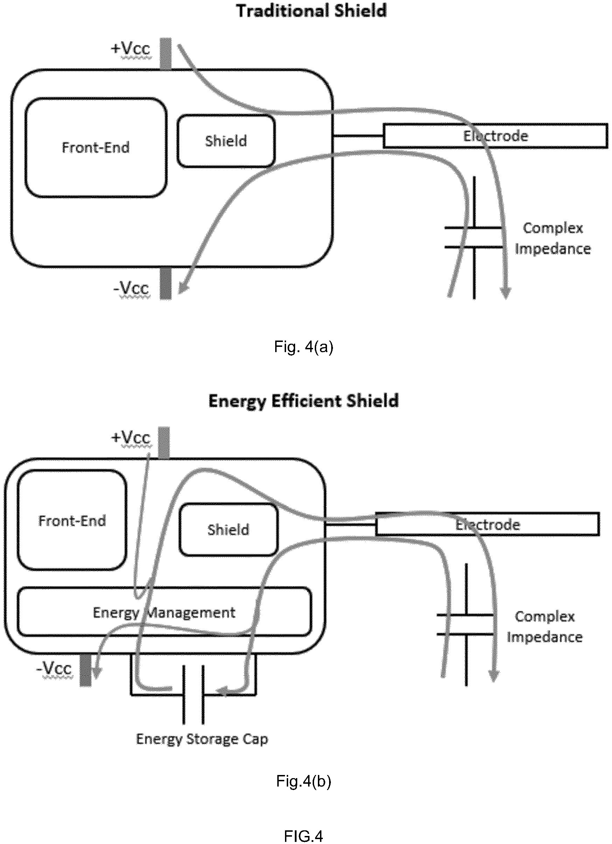

The shield electronics is typically very power consuming. It is normally implemented as a voltage follower buffer that it is constantly draining energy from the supply rails to push it into the shield structure. This large energy requirements makes it difficult to use on devices running of batteries (see fig.4(a)).

The proposed solution is to use a capacitor as energy storage system to move the charge between the storage capacitor and the shield structure. Some energy will be always burned, but a large part of the energy can be maintained and complemented, when required, from the supply rails. A new block called energy management will integrate a set of switches to change the polarisation of the storage capacitor so that it's possible to pump the energy in and out of the capacitor with the less energetic cost possible (fig.4(b)).

### Multilayer shield can sub-module

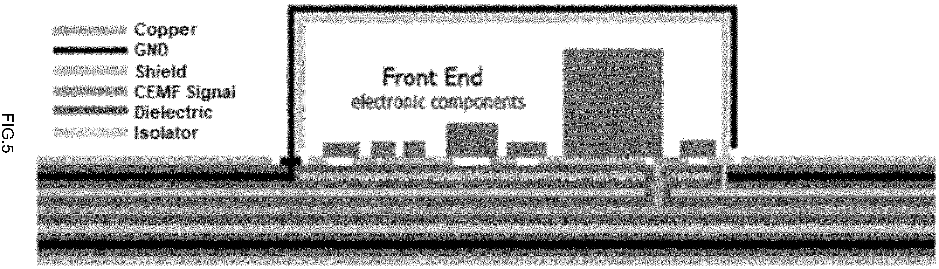

CEMF technology measures relative changes. Therefore, the lower is the load, the higher are the changes in the CEMF signal. To reduce the load, a metallic can connected to shield could be installed around the CEMF front end. This technique has proven to work well, but it exposes a large area of shield to large dynamic changes (like a user's hand touching the device). This kind of changes in the shield can impact on the CEMF signal making it noisy. Therefore, an outer layer of GND has been added to the shield CAN. This way, the sensitivity is improved as the sensor is surrounded by shield, and the sensor becomes immune to large dynamic changes on the can, as the shield layer is protected by a GND layer (Fig.5)

### Detailed description of the electrode management module

As it is previously disclosed, the electrode management module comprises, at least, one of the following sub-modules: an analog CEMF differentiation sub-module; an analog electrode aggregation sub-module; a per-channel compensation sub-module; and/or a flexible electrode mapping sub-module. In the electrode management module, an advanced diagnosis sub-module is also implemented (as well as in other modules).

### Analog CEMF differentiation sub-module

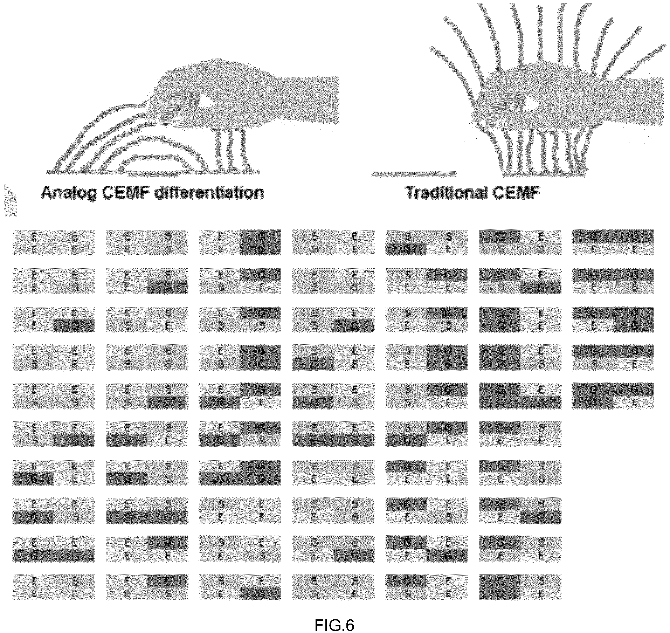

The current CEMF differentiation is done in the digital domain, by subtracting two acquisitions that happen in a different moments of time. A new way of sampling is added, it allows for true differential to happen in the analog domain and on the electromagnetic field itself (FIG.6). For that, each electrode must be able to support 3 stages:
- A CEMF signal to measure
- A shield signal to become CEMF invisible
- An inverted CEMF signal (Or GND) for differential acquisition.

The last stage forces a larger current to flow between the sampling electrode/s and the inverted CEMF signal. Providing for true differential sampling. The combinations of these 3 stages plus the ability to aggregate electrodes allows for an exponential number of combinations, been each of those combinations a CEMF channel (65 channels for 4 electrodes, and 6305 channels for 8 electrodes). In the fig.6 it is shown a combination of the 3 stages (E = CEMF signal; S = Shield signal; G = GND).

### Per-channel compensation

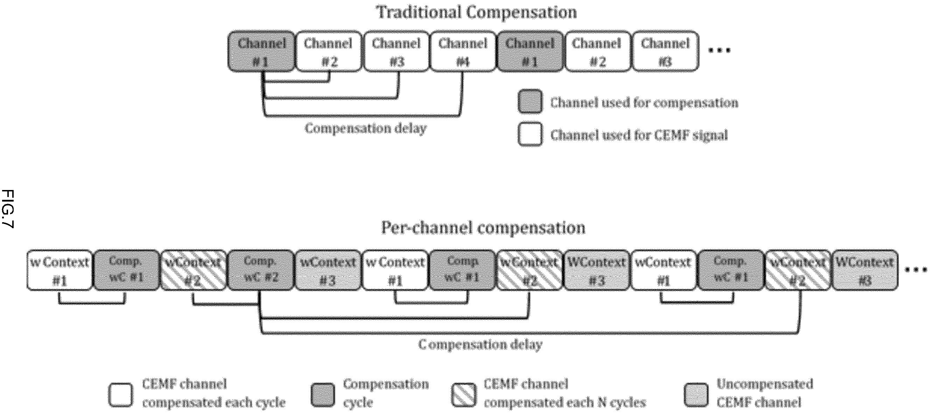

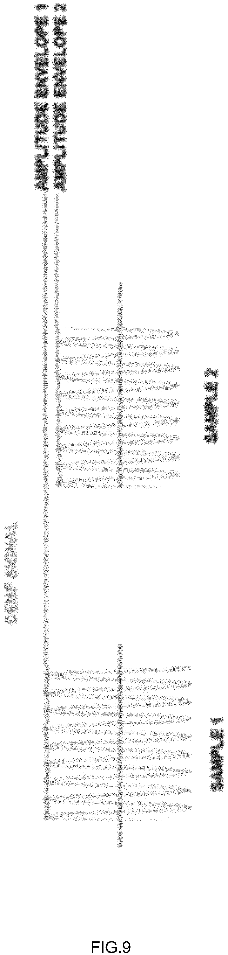

In figure 9 it is shown the prior art channel compensation (FIG.7A) versus the per channel compensation implemented in the present invention (FIG.7B). The CEMF compensation was born by using a CEMF channel to acquire a reference CEMF signal. This eliminated the issues related to temperature/humidity drift, surrounding environment changes, as well as dynamic ground couplings.

CEMF compensation has large benefits, but it also presents some inconvenient like sacrificing one channel or providing different compensation delays per channel. The new per-channel compensation mechanism was design to address these issues. It consists of an extra acquisition cycle (disconnecting the electrode) just right after the CEMF acquisition period. The period of this compensation cycle can be configured to be launched always, or only once every "n" CEMF acquisition cycles. The resolution of the compensation can also be configured. So, in time-sensitive applications it is possible to dedicate less time to compensate and more time to acquire the CEMF signals.

In the example illustrated in FIG.7B, three CEMF channels are operating. Channel 1 has the quickest and most accurate compensation (one per cycle), channel 2 has a slow compensation that allows to waste less power and time but has the price of only been able to compensate slow environmental changes. As shown, this is done by recycling the last known compensation acquisition. The last channel (#3) has no compensation at all.

### Detailed description of the CEMF front-end module

As it is previously depicted in fig.1, the CEMF front-end module comprises, at least, one of the following sub-modules: a CEMF RLC output front-end sub-module; a CEMF magnetic less front-end sub-module; a CEMF envelope acquisition sub-module; a frequency hopping sub-module; and/or a frequency scan sub-module.

### CEMF magnetic less front-end sub-module

Traditionally a CEMF front-end uses magnetics to rise the voltage and generate the CEMF signal. This allows for a high voltage to be generated in the electrode in a very efficient manner. The problem is the space required by the discrete inductors. The solution to this problem is to use integrated equivalent circuits to replace the magnetics. The downside of this technique is that such circuits cannot store energy as a magnetic component does, therefore the power consumption increases dramatically, making it useless in many applications.

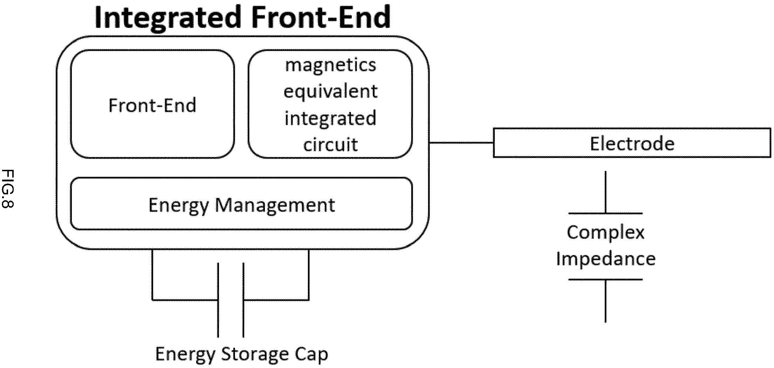

This problem can be solved (fig.8) by combining the magnetics equivalent integrated circuit with a capacitor used as an energy storage element. An energy management module is responsible of providing the energy stored to the equivalent magnetic circuit. So that the energy is transferred back and forth from the energy storage capacitor to the electrode and vice-versa. Losing only the energy burn in inefficiencies as it moves through the front-end electronics.

### CEMF envelope acquisition sub-module

Another improvement with respect to WO2019197677 is in the use of the amplitude value of the CEMF signal. The CEMF signal is the one propagated through the electrode to create the electromagnetic field that is used to sense the presence of objects, animals, or persons. CEMF technology detects and classify electromagnetic field disruptions by looking into changes of this CEMF signal. However, the amplitude of the signal was not considered in the prior art.

The idea here is to use the amplitude of the CEMF signal as an independent parameter that can be used withing the algorithm for further or more precise detection and classification. As can be shown in figure 9, different circumstances surrounding the electrode cause different loads, therefore the CEMF signal will present different amplitude. This amplitude is hold by a voltage tracker that pictures an envelope of the CEMF signal. The voltage of this envelope is then converted to digital by an ADC (analog-to-digital converter) and, if required, reset for a new acquisition. If an amplitude control circuit is used to ensure constant CEMF amplitude, the operation parameters of this circuit will be used instead as independent variable.

### Frequency hopping sub-module

Prior CEMF technology operates in a narrow band of frequency, that means that a strong electromagnetic signal, which matches the current operating frequency, could interfere causing false detections. However, the frequency hopping concept according with the invention acquires the signal in multiple frequencies ranges, and in a random pattern. Therefore, the algorithm works with one signal associated to each frequency range, and if eventually one of these signals suffers of an interference, the algorithm will have the rest of the signals to see that it was an interference as, on a real event, all signals would have change in response.

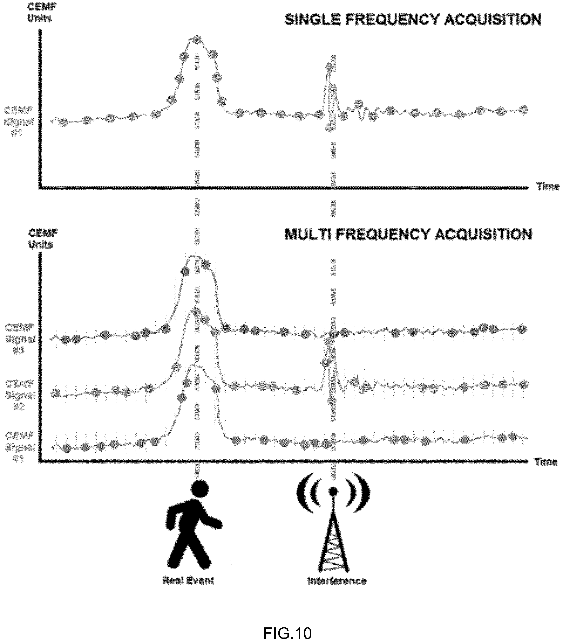

As represented in the figure 10, a real event is detected across all CEMF signals, while an interference is only detected in the frequency matching with the interference signal. The dots indicate where acquisitions will happen, and they are only to illustrate the randomness character of the acquisition pattern/sequence between acquired frequency ranges. The advantage of that is that randomness is what it makes it impossible for an attacker to predict where the next acquisition is going to happen, therefore it eliminates the possibility of someone trying to manipulate the CEMF signal.

### Frequency scan sub-module

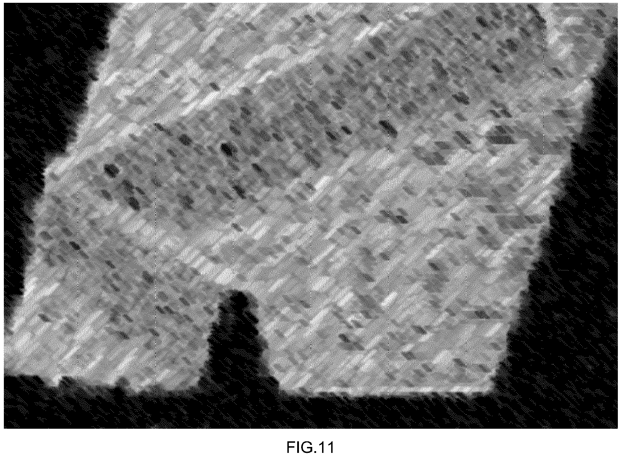

The CEMF signal is a living signal in the sense that its frequency is moving according to the surrounding environment. But, although is moving, each acquisition happens in a single operating point. The idea of frequency scan is to execute the CEMF acquisition across a range of frequencies. This would provide a 3D signal instead a 2D signal to feed the algorithm, as can be shown in figure 11. This 3D data makes for a more robust algorithm that can easily differentiate interferences vs objects as well as materials of different objects.

### Detailed description of the CEMF acquisition module

The CEMF module as it is depicted in fig.1 comprises, at least, the following sub-modules: a flexible differentiation sub-module; a per-channel compensation sub-module; a simultaneous compensation sub-module; a flexible compensation time sub-module; a continuous acquisition sub-module; a fix acquisition time sub-module; a real-time acquisition sub-module; an extended acquisition sub-module; a virtual CEMF acquisition sub-module; a parallel acquisition sub-module; a harmonic acquisition sub-module; a CEMF spectrum acquisition sub-module; a partial acquisition sub-module; a dynamic start-up time sub-module; and/or a CEMF hold-off sub-module. In addition, the CEMF module comprises a per channel sample buffer and an advanced diagnosis sub-module. The per channel compensation module has been previously disclosed (fig.7) and it is implemented also in this module.

### Flexible differentiation sub-module

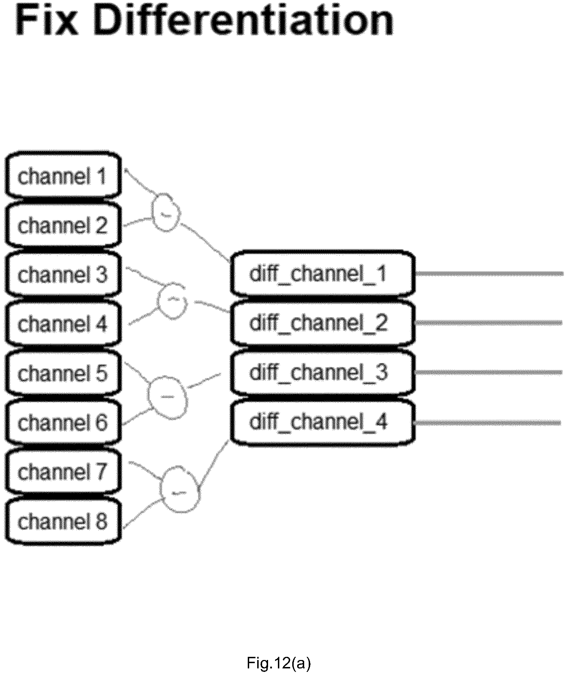

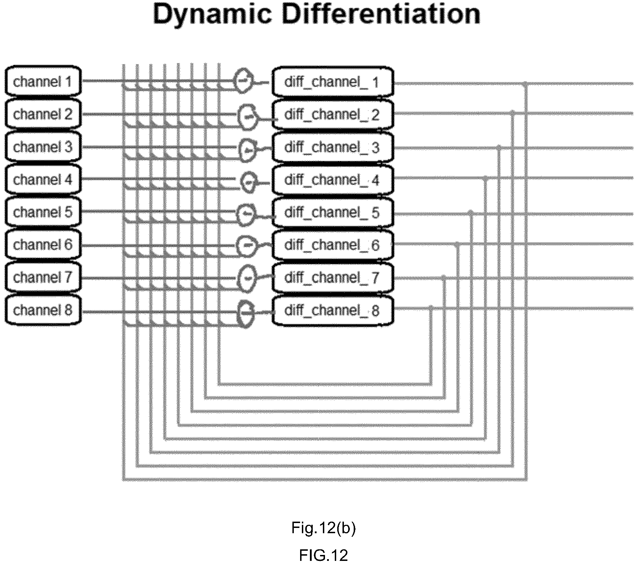

The device in WO2019197677 had the ability to do differential sampling (fig.12(a)), but the user had to choose between 8 single ended channels or 4 differential channels and, when enabled, the configuration was fixed like so that the first differential channel was generated by using the single ended channels 1 and 2, the second differential used single ended channels 3 and 4, and so on and so forth. On contrary, the flexible differentiation scheme of the invention (fig.12(b)) allows for a flexible differentiation. Each channel can be individually set as differential or single ended. So, a mixture of single ended and differential channels can be configured. Also, differential channels can get differentiated with any available channel, (differential or single), including itself. This new differentiation scheme allows for things like share a single ended channel connected to a guard electrode among the rest of channels configured in differential mode.

### Simultaneous compensation sub-module

The idea is to simultaneously acquire the temperature, humidity, supply voltage, or any other parameter used by compensation while the CEMF acquisition process is taking place. Once the CEMF acquisition is finish, the CEMF data is stored together with the compensation data acquired at the same moment of time. So, a more accurate compensation can be achieved.

### Flexible compensation time sub-module

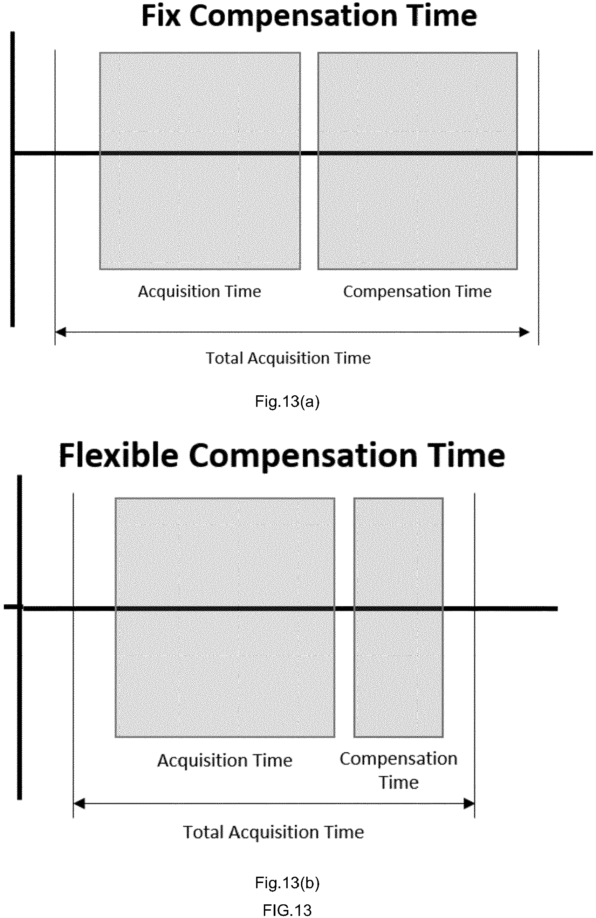

Traditionally, the CEMF signal is compensated on a second execution of the context but disconnecting the electrode and connecting the compensation network instead. When high speed sampling is required, using similar time for compensating and acquiring could be a problem(fig.13(a)). For this reason, an extra set of registers is added to the context configuration, so that the compensation cycle can be executed with a different configuration (fig.13(b)).

### Continuous acquisition sub-module

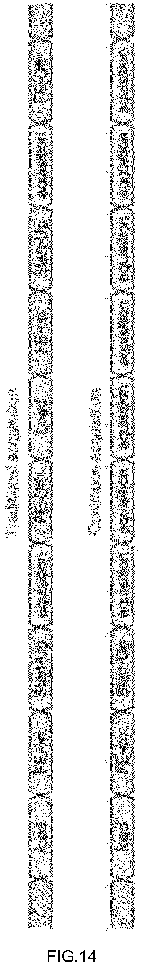

A continuous sampling process was developed with the idea of increasing the sample rate of applications that only require one CEMF channel. When continuous sampling is enabled, acquisitions are done one after another with no delay time between them, saving the time that will otherwise be used to power-off the front-end, reload context, power-up the front-end and wait for stabilisation (fig. 14).

### Real-time acquisition sub-module

The current acquisition process loses information between acquisitions. This is normally not a problem as the information lost is very little. But, in applications where a high sample rate is required, this portion becomes more important as the acquisition time is reduced.

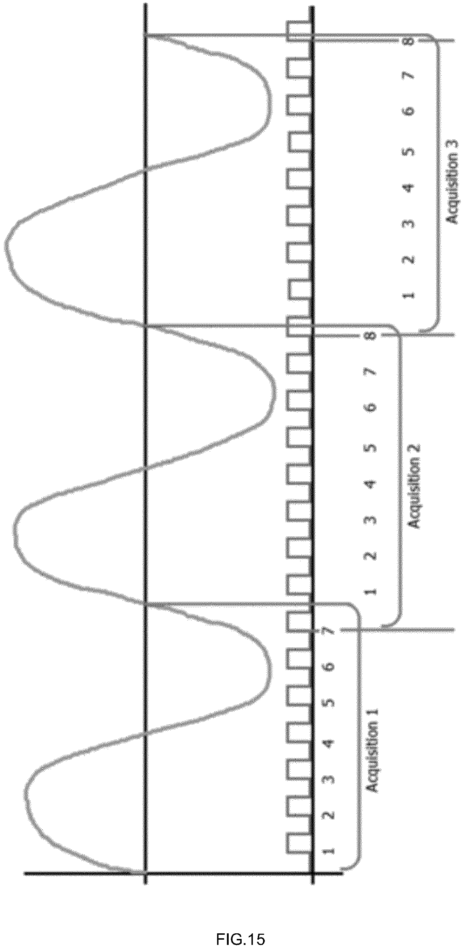

The real time acquisition consists of not losing any portion of information. To do so, two acquisition process are engaged simultaneously. So, that when one process finishes, the other is already started and so the CEMF signal has always been acquired ensuring no information is lost (see fig.15).

### Virtual CEMF acquisition sub-module

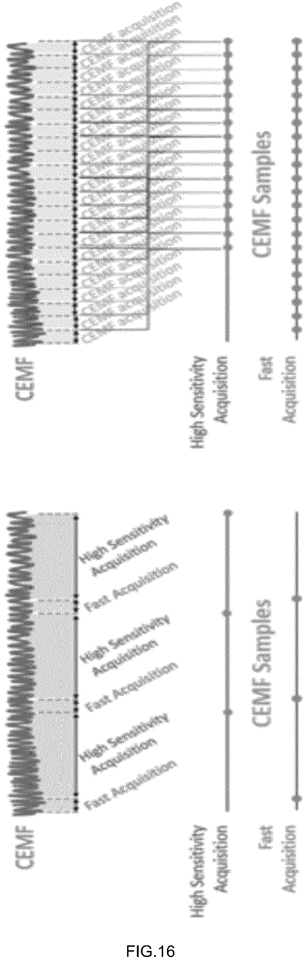

This feature really makes sense with the previously mentioned real time acquisition but can be applied with the traditional acquisition if required. The idea is to store in a buffer the N last acquisitions performed. Then, each context can operate over a virtual acquisition constructed with the accumulation of the M last acquisitions. Traditionally, to increase sensitivity, loner acquisition periods were configured, resulting in low reaction time. By using this technique this high sensitivity sample can be virtually built, achieving high sensitivity and fast reaction time simultaneously. Another advantage of this mechanism is that many virtual acquisitions can be generated from the same real acquisition data stream, allowing multiple algorithms to run with different CEMF signals at high sampling rate (fig.16).

### Extended acquisition sub-module

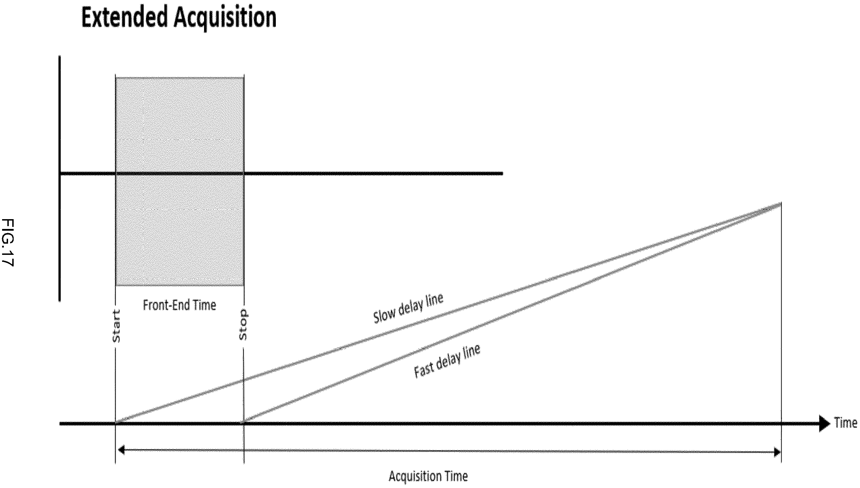

Traditionally, the CEMF acquisition requires the CEMF front-end to be powered along the whole acquisition process. To save power, it would be required to switch off the front-end while the acquisition continues working. The solution implemented in the invention is to combine the CEMF technology with Vernier delay lines concept; starting the slow line with the first CEMF cycle and starting the fast line with the cycle that counts N (decided by the user). This time will work as time seed to the acquisition that will continue working for as long as the fast line takes to overtake the slow one. This mechanism works as a time amplifier with an amplification ratio inversely proportional to the difference between propagation speed of the two delay lines (fig.17. The same idea can be implemented with a slow and fast counters that will finish the acquisition when the fast counter equals the slow one.

### Parallel acquisition sub-module

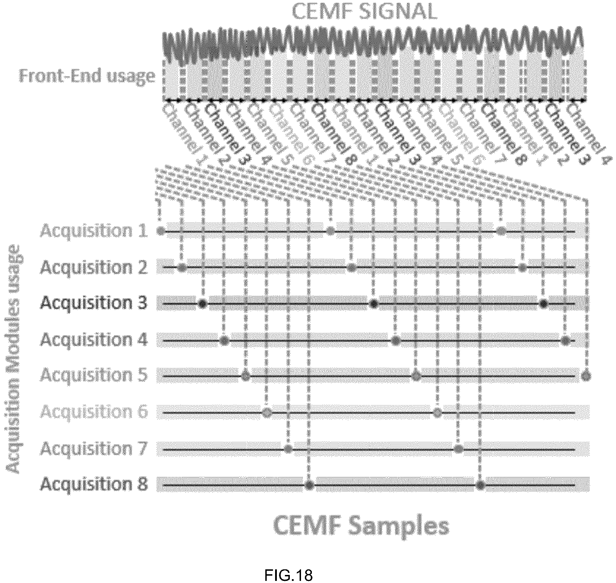

Traditionally, the CEMF acquisition requires the CEMF front-end to be powered along the whole acquisition process. Therefore, only one context can acquire simultaneously. To increment the acquisition rate, it is required to find a mechanism capable of sharing the front-end while the acquisition is taking place. The extended acquisition sub-module according with the invention works as a time amplifier, taking just a time seed, and extending the acquisition for a longer period. That enables the possibility to integrate many acquisition blocks and arrange the configuration so that all contexts are simultaneously acquiring while the front-end moves across contexts (fig.18).

### Harmonic acquisition sub-module

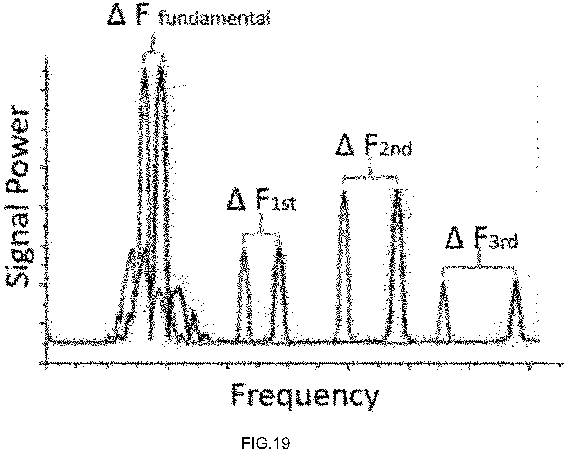

By working with harmonic or sub-harmonic of the fundamental frequency it is possible to obtain several benefits. For instance, the harmonic will increase the frequency difference and increase the sampling rate. Meanwhile, the sub-harmonic, if present, can be used to increase the sensitivity. As it can be seen in fig.19, the frequency variation between samples increases as we move to higher CEMF signal harmonics.

### CEMF spectrum acquisition sub-module

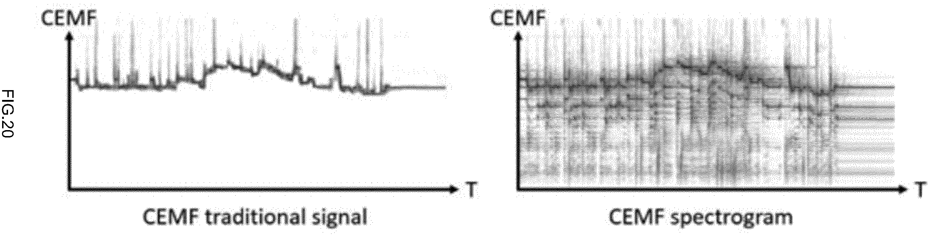

A spectrum analysis is carried out on each acquisition, it would be possible to see not only how the CEMF frequency moves, but also how the harmonics perform or if there is any frequency alteration due to any active object in range. This feature helps to identify the nature of the elements in range of the CEMF electromagnetic field (fig.20).

### Partial acquisition sub-module

In the prior art, the acquisition process provides no visibility of how the CEMF signal (i.e., the signal from the electrode) is evolving along the acquisition process. The partial acquisition provides visibility along this process with as many intermediate steps as desired. This means that if a disruption on the electromagnetic field is large enough to be detectable before the end of the acquisition, the algorithm can see it and react to it earlier. Saving time and accelerating the response time of the application.

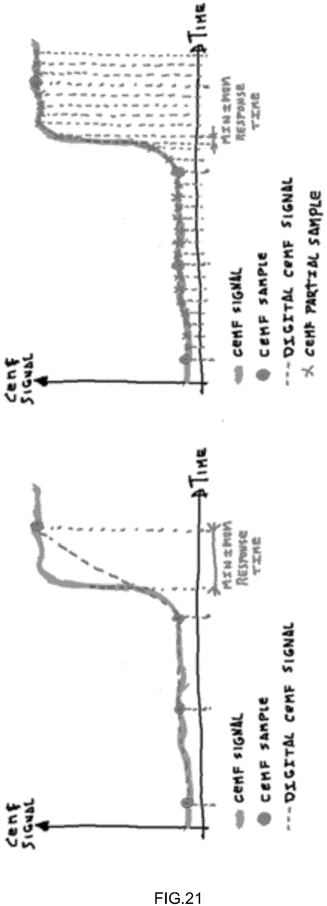

In fig.21 a CEMF signal change to a real event is represented as a rapid ascending change on the CEMF signal. Through traditional sampling, the algorithm only has visibility of the CEMF signal through the CEMF samples (highlighted with dots). Instead, the partial acquisition sees many more steps in between. Therefore, by using partial acquisition according with the present invention, the application can react faster than using traditional sampling, but equally important is that the application will not lose sensitivity, as the acquisition is still operating over the same period.

### Dynamic start-up time sub-module

When the CEMF starts operating there is an initial period where the signal is not yet stable. This period is called start-up time. In the prior art, the acquisition starts a fix time before operating, this time is calculated and hardcoded by the CEMF engineers working in a particular application. But even though it has been estimated for the application, there are differences between boards or environments. Therefore, the defined start-up time needs to be over-dimensioned to make sure it covers the worst case. This also means that, in nominal cases, there is time and energy wasted waiting for a start-up time longer than needed.

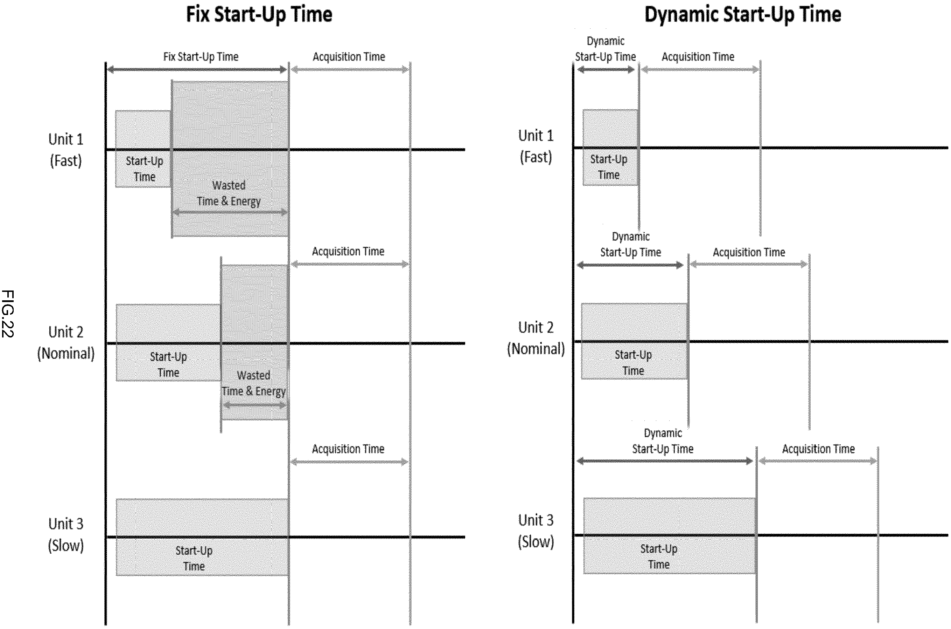

The dynamic start-up time (fig.22), as soon as the front-end starts, the CEMF signal is monitored for stability. As soon as a stability threshold configurable by the user is reached, the start-up period is finished. This allows to start the acquisition just right after the CEMF front end is operating on a stable condition. Therefore, it helps using the minimum amount of time and energy as possible.

### Detailed description of the memory module

In the fig.1 it is depicted the memory module that comprises, at least, one of the following sub-modules: a virtual CEMF channel sub-module; a flexible scan sequence sub-module; and/or a flexible differentiation sub-module.

### Virtual CEMF channel sub-modules

In figure 28 it is disclosed a traditional implementation using Wardiam modules inside an ASIC as well as the new implementation according with the present invention, using virtual channels. The difference between Wardiam modules to be included in the present invention relays on the configuration written in the registers. Therefore, the goal is reducing the silicon area used in the ASIC implementation. To do so, it has been implemented a mechanism that allows for the reuse of a single Wardiam module to behave like many. To accomplish this, it is required to fetch the module configuration and the value of some internal registers required. The set of configuration and internal registers implements a virtual CEMF channel or context.

Therefore, for power saving reasons, the implementation detects when the next context to be executed is different from the current one to avoid memory accesses to load a context that is already loaded. In WO2019197677 the user was able to specify the number of channels to be used. But the scan sequence was fix from electrode #1 until the number configured. The present invention provides a flexible sequencer so that any scan patterns can be implemented, including scanning the same virtual CEMF channel several times per iteration.

### Flexible differentiation sub-module

In the memory module it also can be implemented the flexible differentiation module according to fig.12, previously disclosed with respect to the CEMF module.

### Detailed description of the communications module

In the communication module it is implemented a smart interrupts sub-module. The device in WO2019197677 handles many types of events (Errors, Start of Conversion, End of Conversion, CEMF noise, CEMF event, etc). If a dedicated interrupt per event type is desired, the number of required pins/balls in the pad-ring and the ASIC package becomes very large. This fact increases the silicon size, the ASIC size, the cost as well as impacts in the yield. Therefore, it has been decided to have a couple of programable interrupt pins/balls that can be associated to any event type or to a set of types. If more than one event type is mapped to an interrupt, a OR/AND combination need to be chosen as aggregation method (fig.30).

### Detailed description of the system manager module

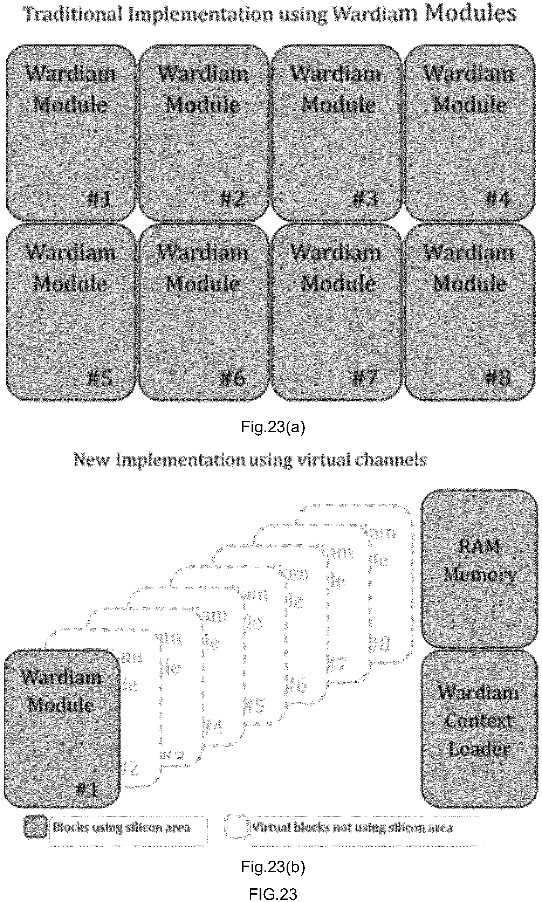

The system manager module comprises at least one of the following sub-modules: a virtual CEMF channel sub-module (previously disclosed, fig.23); a continuous acquisition sub-module (previously disclosed, fig.14); and/or an always on SYS_CLK sub-module.

### Fix sequence time sub-module

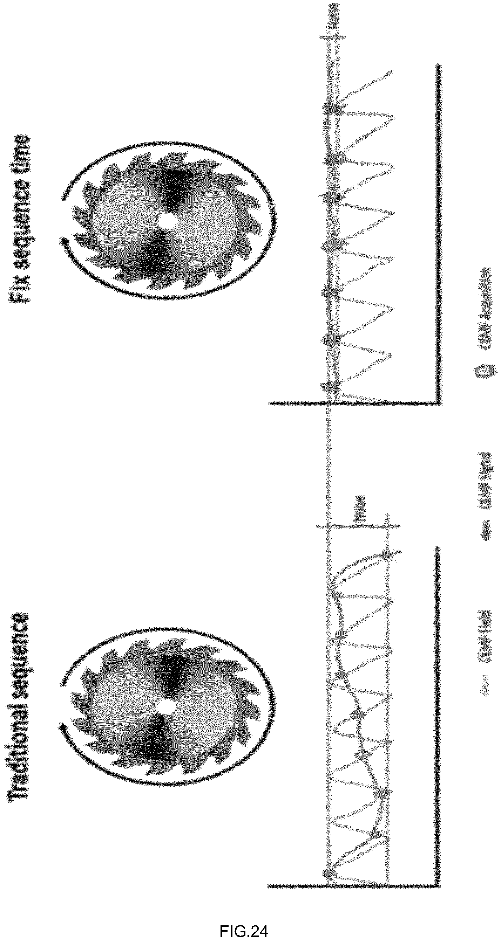

Due to the nature of the start-up and acquisition process, the CEMF sequence does not have a deterministic period. Therefore, it is not possible to align the acquisitions with a periodic phenomenon like the AC power (50Hz-60Hz) or a motor turning (hundreds of rpm). In some applications this may be a significant disadvantage as the result is a large noise mapped into the signal due to acquisitions happening in different conditions. However, the fix sequence time ensures each sequence step starts precisely at the same distance of the one before and the one next, enabling CEMF to be synchronised with cyclic physical phenomena (fig.24).

### Always on SYS_CLK sub-module

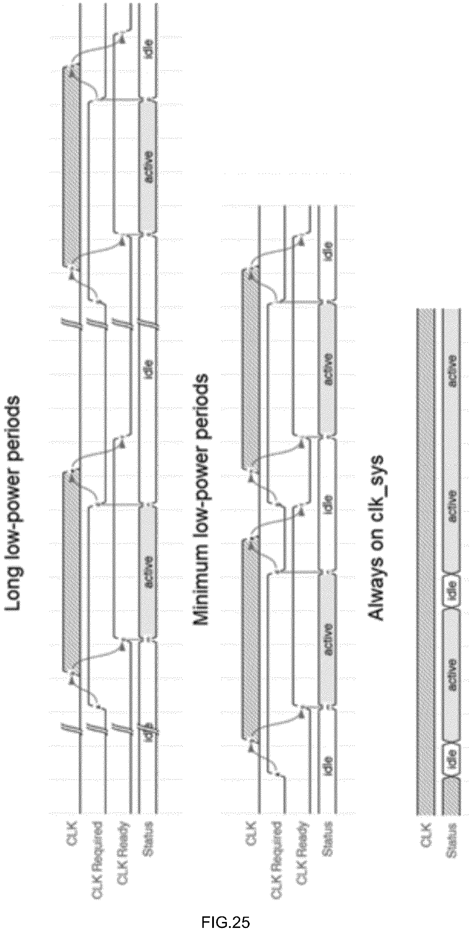

To support low power applications, WO2019197677 implements two clock sources: a first fast clock and a second slow clock. The slow clock is always on, and the fast is switched on only when required. The process of switch on and off a clock source is not immediate. Therefore, there is a portion of time and energy wasted on each on/off transition. This is fine when the application is operating at a low sample rate, but as the sample rate increases, this time starts to be relevant till the point of preventing a further increase of the sample rate. Therefore, the feature always on CLK_SYS was implemented in the present invention (fig.25). This feature basically maintains the fast clock always enable. Allowing SPI communications, acquisitions and any other operation that requires the fast clock to occur at any time avoiding the fast clock start-up delay. As show in the fig.25, the low power scheme has a minimum idle time. Always on CLK_SYS feature allows to go to idle for shorter periods of time or even to remain in active for as long as required.

Various means of embodiment provided by this description may be implemented using hardware, software, or combinations of hardware and software. As also may be the case, the different components of hardware and/or software established in this document may be combined in composite materials comprising software, hardware and/or both, without deviating from the object of this invention defined by its claims. The different components of hardware and/or software established in this document can be separated in the sub-components comprising software, hardware, or both, without deviating from the object of this invention defined by its claims. As also may be the case, it is considered that the software components can be used as hardware components and vice versa. The software according to this description, such as non-transitory instructions, programme and/or data, code, can be stored in one or more legible means of the non-transitory machine. It is also considered that the software identified in this document can be implemented using one or more general-purpose, or specific-purpose, computers and/or computer systems, in a network and/or of another type. The order of the different steps described in this document can be changed and/or divided into substages to deliver the characteristics described in this document. The means of embodiment described above illustrate, but do not limit, the invention. It should also be understood that numerous modifications and variations are possible according to the object of this invention. Consequently, the scope of the invention is only defined by the following claims.

## Claims

1. A device to measure disruptions in a controlled electromagnetic field comprising:
a CEMF shield module further comprising at least one of the following sub-modules: a tracking GND high voltage shield sub-module; an RLC-circuit based shield; an energy efficient shield; and/or a multilayer shield can;
an electrode management module further comprising at least one of the following sub-modules: an analog CEMF differentiation sub-module; and/or a per-channel compensation sub-module;
a CEMF front-end module further comprising at least one of the following sub-modules: a CEMF magnetic less front-end sub-module; a CEMF envelope acquisition sub-module; a frequency hopping sub-module; and/or a frequency scan sub-module;
a CEMF acquisition module further comprising at least one of the following sub-modules: a flexible differentiation sub-module; a per-channel compensation sub-module; a simultaneous compensation sub-module; a flexible compensation time sub-module; a continuous acquisition sub-module; a real-time acquisition sub-module; an extended acquisition sub-module; a virtual CEMF acquisition sub-module; a parallel acquisition sub-module; a harmonic acquisition sub-module; a CEMF spectrum acquisition sub-module; a partial acquisition sub-module; and/or a dynamic start-up time sub-module;
a memory module further comprising at least one of the following sub-modules: a virtual CEMF channel sub-module; a flexible scan sequence sub-module; and/or a flexible differentiation sub-module;
a communications module comprising a smart interrupts sub-module; and
a system manager module further comprising at least one of the following sub-modules: a virtual CEMF channel sub-module; a continuous acquisition sub-module; a fix sequence time sub-module; and/or an always on SYS_CLK sub-module.

2. The device according to claim 1 wherein the tracking GND high voltage shield sub-module comprises at least one slow high voltage buffer with at least one fast low voltage buffer being arranged to deliver a high-voltage and high-speed signal to shield a high voltage CEMF signal; and/or
the RLC-circuit based shield sub-module is arranged for a shield signal generation from a single positive low voltage rail and comprises a RLC-circuit and a close loop control circuit arranged to build a sinusoidal signal that matches frequency, phase, and amplitude of the input signal; and/or
the energy efficient shield sub-module comprises a capacitor arranged as energy storage system arranged to move the charge between the storage capacitor and the shield structure; and an energy management circuit comprising a plurality of switches arranged to change the polarisation of the capacitor to pump the energy in and out of the capacitor; and/or the multilayer shield can sub-module comprises a metallic can connected to the shield around the CEMF front-end and an outer layer of GND added to the shield can.

3. The device according to any of claims 1 to 2 wherein the analog CEMF differentiation sub-module is arranged to sample the CEMF signal in the analog domain and on the electromagnetic field itself throughout the combination of a CEMF signal to measure; a shield signal; and an inverted CEMF signal or GND for differential acquisition; and/or
the per-channel compensation sub-module is configured for an extra acquisition cycle disconnecting an electrode just right after the CEMF acquisition period.

4. The device according to any of claims 1 to 3 wherein the CEMF magnetic less front-end sub-module comprises an equivalent magnetic integrated circuit with a capacitor used as an energy storage element and an energy management module arranged for providing the energy stored in the capacitor to the equivalent magnetic circuit, so that the energy is transferred forth and back from the capacitor; and/or
the CEMF envelope acquisition sub-module comprises a voltage tracker to envelope the amplitude of the CEMF signal as a voltage signal used as an independent parameter for further or more precise detection and classification of the measured CEMF signal; and/or
the frequency hopping sub-module is arranged to acquire the CEMF signal in a plurality of frequency rages in a random pattern; and/or
the frequency scan sub-module is arranged to execute the CEMF acquisition across a range of frequencies.

5. The device according to any of claims 1 to 4 wherein the flexible differentiation sub-module is arranged to set individually each acquisition channel as single ended or differential; and/or
the simultaneous compensation sub-module comprises a set of sensors arranged to acquire relevant physical phenomena while the CEMF acquisition is taking place and to store the data together with the CEMF acquisition data;
and/or the flexible compensation time sub-module comprises an extra set of registers added to the context configuration and arranged to execute the compensation cycle with a different configuration;
and/or the continuous acquisition sub-module is arranged to acquire the CEMF signal one after another in the same one CEMF channel with minimum delay time between each individual acquisition;
and/or the real-time acquisition sub-module is arranged for, when an acquisition finishes, a second acquisition module was already acquiring;
and/or the virtual CEMF acquisition sub-module is arranged to store in a buffer the N last performed acquisitions; and then, each context is arranged to operate over a virtual acquisition constructed with the accumulation of the M last acquisitions; and/or
the extended acquisition sub-module comprises the combination of CEMF acquisition with Vernier delay lines, starting the slow line with the first CEMF cycle and starting the fast line with the cycle that counts a number decided by the user; alternatively, a fast and slow counter are used; and/or
the parallel acquisition sub-module is a time amplifier taking just a time seed and extending the acquisition for a longer period. This allows to instantiate many acquisition modules simultaneously acquiring the time seeds captured from a shared front-end; and/or
the harmonic acquisition sub-module is arranged to work with harmonic or sub-harmonic of the fundamental frequency of the CEMF signal; and/or
the CEMF spectrum acquisition sub-module is arranged to perform a spectrum analysis of the CEMF signal; and/or
the partial acquisition sub-module is arranged to divide the CEMF signal into intermediate steps before the end of the acquisition; and/or
the dynamic start-up time sub-module is arranged to monitor the stability of the CEMF signal and start the acquisition based on a stability threshold configurable by the user rather than on time.

6. The device according to claims 1 to 5 wherein the virtual CEMF channel sub-module is arranged for the reuse of a single CEMF module to behave like a plurality of modules; and/or
the fix sequence time sub-module is arranged to ensure that each sequence step starts precisely at the same distance of the one before and the one next, enabling CEMF to be synchronised with cyclic physical phenomena; and/or
the always-on SYS_CLK sub-module is arranged to maintain a fast clock always enable and to allow SPI communications, acquisitions and any other operation, that requires the fast clock, to occur at any time avoiding the fast clock start-up delay.

7. A method to measure disruptions in a controlled electromagnetic field comprising:
a CEMF shield process further comprising at least one of the following steps: a tracking GND high voltage shield step; an RLC-circuit based shield step; an energy efficient shield step; and/or a multilayer shield can step;
an electrode management process further comprising at least one of the following steps: an analogic CEMF differentiation step and/or a per-channel compensation step;
a CEMF front-end process further comprising at least one of the following steps: a CEMF magnetic less front-end step; a CEMF envelope acquisition step; a frequency hopping step; and/or a frequency scan step;
a CEMF acquisition process further comprising at least one of the following steps: a flexible differentiation step; a per-channel compensation step; a simultaneous compensation step; a flexible compensation time step; a continuous acquisition step; a real-time acquisition step; an extended acquisition step; a virtual CEMF acquisition step; a parallel acquisition step; a harmonic acquisition step; a CEMF spectrum acquisition step; a partial acquisition step; and/or a dynamic start-up time step;
a memory process further comprising at least one of the following steps: a virtual CEMF channel step; a flexible scan sequence step; and/or a flexible differentiation step;
a communications process comprising a smart interrupts step; and
a system manager process further comprising at least one of the following steps: a virtual CEMF channel step; a continuous acquisition step; a fix sequence time step; and/or an always on SYS_CLK step.

8. The method according to claim 7 wherein:
the tracking GND high voltage shield step comprises at least one slow high voltage buffer with at least one fast low voltage buffer being arranged to deliver a high-voltage and high-speed signal to shield a high voltage CEMF signal; and/or
the RLC-circuit based shield step comprises to build a sinusoidal shield signal that matches frequency, phase, and amplitude of the input signal; and
the energy efficient shield step comprises to move the charge between a storage capacitor and the shield planes; and to change the polarisation of the capacitor to pump the energy in and out of the capacitor; and/or the multilayer shield can sub-module comprises a metallic can connected to the shield around the CEMF front-end and an outer layer of GND added to the shield can.

9. The method according to any of claims 7 to 8 wherein:
the analog CEMF differentiation step comprises sampling the CEMF signal in the analog domain and on the electromagnetic field itself throughout the combination of the CEMF signal to measure, the shield signal, and the inverted CEMF signal or GND for differential acquisition; and/or
the per-channel compensation step comprises an extra acquisition cycle disconnecting an electrode just right after the CEMF acquisition period.

10. The method according to any of claims 7 to 9 wherein:
the CEMF magnetic less front-end step comprises transferring back and forth the energy stored in a capacitor to an equivalent magnetic circuit; and/or
the CEMF envelope acquisition step comprises to envelope the amplitude of the CEMF signal as a voltage signal used as an independent parameter for further or more precise detection and classification of the measured CEMF signal; and/or
the frequency hopping step comprises to acquire the CEMF signal in a plurality of frequency ranges in a random pattern; and/or
the frequency scan step comprises to execute the CEMF acquisition across a range of frequencies.

11. The method according to any of claims 7 to 10 wherein:
the flexible differentiation step comprises to set individually each acquisition channel as single ended or differential; and/or
the simultaneous compensation step comprises to acquisition of physical phenomena while the CEMF acquisition is taking place and to store the compensation data together with the CEMF acquisition data; and/or
the flexible compensation time step comprises to add an extra set of register to the context configuration to execute the compensation cycle with a different configuration; and/or
the continuous acquisition step comprises to acquire the CEMF signal one after another in the same one CEMF channel with minimum delay time between each individual acquisition; and/or
the real-time acquisition step comprises a second acquisition module already acquiring when a previous acquisition finish, and the CEMF signal has always been acquired in real time; and/or

12. The method according to any of claims 7 to 11 wherein:
the virtual CEMF acquisition step comprises to store in a buffer the N last performed acquisitions; and then, each context is arranged to operate over a virtual acquisition constructed with the accumulation of the M last acquisitions; and/or
the extended acquisition step comprises the combination of CEMF acquisition with Vernier delay lines, starting the slow line with the first CEMF cycle and starting the fast line with the cycle that counts a number decided by the user; alternatively, a fast and a slow counter are used; and/or
the parallel acquisition step comprises a time amplification taking just a time seed and extending the acquisition for a longer period. This allows to instantiate many acquisition modules simultaneously acquiring the time seeds captured from a shared front-end; and/or
the harmonic acquisition step comprises to work with harmonic or sub-harmonic of the fundamental frequency of the CEMF signal; and/or
the CEMF spectrum acquisition step comprises to perform a spectrum analysis of the CEMF signal; and/or
the partial acquisition step comprises to divide the CEMF signal into intermediate steps before the end of the acquisition.

13. The method according to any of claims 7 to 12 wherein:
the dynamic start-up time step comprises to monitor the stability of the CEMF signal and start the acquisition based on a stability threshold configurable by the user rather than on time; and/or the virtual CEMF channel step comprises for the reuse of a single CEMF module to behave like a plurality of modules; and/or
the fix sequence time step comprises to ensure that each sequence step starts precisely at the same distance of the one before and the one next, enabling CEMF to be synchronised with cyclic physical phenomena; and/or
the always on SYS_CLK step comprises to maintain a fast clock always enable and to allow SPI communications, acquisitions and any other operation that requires the fast clock to occur at any time avoiding the clock start-up delay.

14. Use of the device according to any of claims 1-6 to measure electromagnetic fields surrounding a conductor for the localisation of people, mixed reality, devices, loT, domestic and industrial security applications, robotics, military applications, and security applications for transporting cargo and people, work-related and domestic prevention and security applications and applications for the logistics sector and fluid control and detection in bathrooms.
